# EUROPEAN PATENT SPECIFICATION

(11) **EP 3 493 278 B1**
(45) Date of publication and mention of the grant of the patent: **10.06.2020**
(21) Application number: 18209301.3
(22) Date of filing: 29.11.2018
(51) Int. Cl.: H01L 31/18

(54) **APPARATUS FOR ELECTRICALLY CONNECTING PHOTOVOLTAIC CELLS IN SERIES AND METHOD FOR OPERATING SAID APPARATUS**
VORRICHTUNG UND VERFAHREN ZUR ELEKTRISCHEN VERBINDUNG VON SOLARZELLEN.
DISPOSITIF DE CONNECTION EN SERIE DE CELLULES PHOTOVOLTAIQUES ET PROCÉDÉ D'OPERATION DE TEL DISPOSITIF.

(30) Priority: 30.11.2017 IT 201700138302
(43) Date of publication of application: 05.06.2019
(73) Proprietor: Futurasun S.R.L., 35013 Cittadella (PD) (IT)
(72) Inventor: BAGGIO, Nicola, 35013 Cittadella (PD) (IT); SGARBOSSA, Manuel, 35014 Fontaniva (PD) (IT)
(74) Representative: Caldon, Giuliano

(56) References cited:
- CN-U- 206 584 944
- DE-A1- 3 238 187
- US-A- 4 450 033
- US-A1- 2007 079 862
- US-A1- 2012 269 226

## Description

### Field of application

The present invention regards an apparatus for electrically connecting photovoltaic cells in series and a method for operating said apparatus, according to the preamble of the respective independent claims.

The present apparatus is intended to be employed in the industrial processes of production of photovoltaic panels, for electrically connecting multiple photovoltaic cells in series with each other which will be part of the photovoltaic panels themselves.

### State of the art

As is known, the photovoltaic panels widespread on the market are generally constituted by the joining of multiple photovoltaic cells, which are joined in series with each other in order to form a string of cells.

For example, photovoltaic panels widespread on the market comprise six rows of ten photovoltaic cells each, for a total of sixty photovoltaic cells for each photovoltaic panel.

In brief, the process of production of the photovoltaic panels provides for electrically connecting the photovoltaic cells in series, obtaining multiple rows of cells, which are subsequently arranged on an ethylene vinyl acetate (EVA) support and covered with a glass panel. Such multilayer assembly is subjected to thermal treatment in suitable ovens, causing the softening of the EVA support, which is fixed in this manner to the cells and to the glass.

As is known, each photovoltaic cell is substantially constituted by a sheet-like body made of semiconductor material (typically silicon), which comprises two superimposed layers of semiconductor material which define the two surfaces of the photovoltaic cell. Of the two semiconductor material layers, one is doped with boron atoms, becoming a "p-type" semiconductor, and the other is doped with phosphorus atoms, becoming an "n-type" semiconductor.

The contact of the two layers of p-type and n-type semiconductor material creates the so-called "p-n junction", through which an excess of electrons present in the n-type semiconductor is susceptible of passing into the p-type semiconductor, generating an electric field, and hence a potential difference between the two sheet-like bodies.

In order to be able to generate an electric current, the photovoltaic cell is arranged with its n-type surface directed towards the sun. In this manner, the light photos present in the solar radiation are susceptible of hitting the electrons in proximity to the p-n joint, providing the sufficient energy thereto so that there is a passage of electronics from the p-type semiconductor to the n-type semiconductor.

In this manner, the surface of the photovoltaic cell made with the n-type semiconductor acts as negative pole, while the surface made with the p-type semiconductor acts as positive pole.

By joining, with one or more electrical conductors, each surface made with the n-type semiconductor with the surface made with the p-type semiconductor of the successive photovoltaic cell, a connection is generated in series of the various photovoltaic cells arranged in succession, which allows summing together the various potential differences generated by each cell in order to obtain the desired total potential difference.

The photovoltaic cells of each panel are connected to each other in series by means of electrical conductors, known in the jargon of the field as "ribbons", which are constituted by copper wires covered by a tin alloy, fixed on a surface of a photovoltaic cell and on the opposite surface of the successive photovoltaic cell.

Conventionally, the photovoltaic cells are connected in series with each other by means of four electrical conductors, each of which welded to each cell, for example, at ten welding points for a total of forty welding points for each photovoltaic cell.

In order to simplify the welding operation, the conventionally-used electrical conductors have ribbon form, with a substantially rectangular section, so as to increase the section of the welding point and simplify the welding operation.

Nevertheless, an electrical conductor of ribbon-like type blocks a considerable portion of photovoltaic cell, which cannot receive the solar radiation and hence cannot contribute to the operation of the photovoltaic cell in its entirety, thus involving a drop of efficiency of the entire photovoltaic panel.

In order to limit such drawback, filiform conductors with circular section and more slender diameter were introduced on the market, such to reflect the solar rays that hit such conductors towards the photovoltaic cells and reduce the covered surface of the panel.

In the process of production of the photovoltaic panels, automated apparatuses are employed that are adapted to connect the cells in series, termed "stringer" machines in the field of the art.

The stringer machines of known type conventionally comprise a conveyor belt on which the photovoltaic cells are loaded in succession, at a loading section of the machine.

The stringer machine also comprises multiple reels arranged at the loading station, the corresponding electrical conductor being wound on each of these; such conductor is unwound on the cells loaded on the conveyor belt. The latter is driven to advance stepwise in order to convey the photovoltaic cells to a welding device adapted to fix the electrical conductors to the photovoltaic cells themselves.

In operation, with each movement step, the conveyor belt carries a photovoltaic cell below the welding device, which is then brought into contact with the metal conductors at specific welding points. For example, an electrical conductor is welded to each photovoltaic cell in about a dozen points, in order to ensure a suitable electrical connection.

After the contact with the welding device, the tin of the electrical conductor only melts in the welding points and, at such points, comes to be welded with the silicon of the photovoltaic cell with which it is associated.

Subsequently, the welding device is separated from the photovoltaic cell and the conveyor belt advances at another step in order to bring the successive photovoltaic cell below the welding device.

The stringer machines of known type described in brief up to now have in practice shown that they do not lack drawbacks.

More in detail, one drawback of such stringer machines lies in the fact that the conveyor belt proceeds in an intermittent manner, since it is commanded to be stopped each time a cell reaches a welding device in order to allow the latter to act on electrical conductors. Such intermittent operation of the stringer machines of known type involves an inevitable elongation of the production times for a string of photovoltaic cells and a consequent increase of the costs of production of the photovoltaic panels.

A further drawback lies in the fact that the welding device heats the electrical conductors only at the welding points, determining zones of the cells at high temperatures (about 200° C) and other zones at low temperatures (about 50° C). Consequently, the high-temperature material tends to be expanded via heat expansion but is prevented by the surrounding lower-temperature material, facilitating the formation of cracks.

A further drawback of the stringer machines of known type is due to the fact that their welding devices are not suitable for precisely and efficiently welding, on each photovoltaic cell, numerous conductors with circular section and relatively slender diameter.

The document US 2007/079862 describes a stringer machine, which is provided with two first conveyor belts susceptible of receiving photovoltaic cells and electrical conductors to be welded with each other. In particular, the aforesaid two first conveyor belts are arranged one after the other in order to form an advancement lane of the photovoltaic cells and of the electrical conductors, which is placed to cross a welding station. In addition, the machine described in US 2007/079862 is provided with a second conveyor belt, arranged above the two first conveyor belts and actuatable to advance in an advancement direction in accordance with the advancement direction of the two first conveyor belts in order to drive the photovoltaic cells and the electrical conductors to cross the welding station.

One drawback of the apparatus described in the document US 2007/079862 derives from the fact that, in order to prevent oxidation phenomena during welding, it requires arranging the welding station within a chamber with inert gas atmosphere, with consequent high production costs.

The documents US 4,450,033 and DE 3238187 describe examples of machines for producing photovoltaic cells provided with advancing belts for conveying the photovoltaic cells themselves. Such machines are not provided with means for electrically connecting the photovoltaic cells in series and therefore cannot be classified as stringer machines.

### Presentation of the invention

The subject matter of the present invention is defined in claims 1 and 15. In this situation, the problem underlying the present invention is therefore that of overcoming the drawbacks manifested by the stringer machines of known type, by providing an apparatus for electrically connecting photovoltaic cells in series and a method for operating said machine, which allow quickly and efficiently operating.

A further object of the present invention is to provide an apparatus for electrically connecting photovoltaic cells in series, which is able to carry out the welding of the electrical conductor in a uniform manner over the entire the surface of the photovoltaic cell, avoiding the onset of cracks due to the thermal expansion of the various materials. A further object of the present invention is to provide an apparatus for electrically connecting photovoltaic cells in series which is able to efficiently operate even with electrical conductors of limited section.

A further object of the present invention is to provide an apparatus for electrically connecting photovoltaic cells in series which is able to operate in a continuous and uninterrupted manner.

A further object of the present invention is to provide an apparatus for electrically connecting photovoltaic cells in series which is safe and reliable in use.

A further object of the present invention is to provide an apparatus for electrically connecting photovoltaic cells in series which is able to efficiently weld numerous electrical conductors (e.g. twelve) to the photovoltaic cells.

### Brief description of the drawings

The technical characteristics of the invention, according to the aforesaid objects, can be clearly seen in the contents of the below-reported claims and the advantages thereof will be more evident in the following detailed description, made with reference to the enclosed drawings, which represent a merely exemplifying and non-limiting embodiment of the invention, in which:

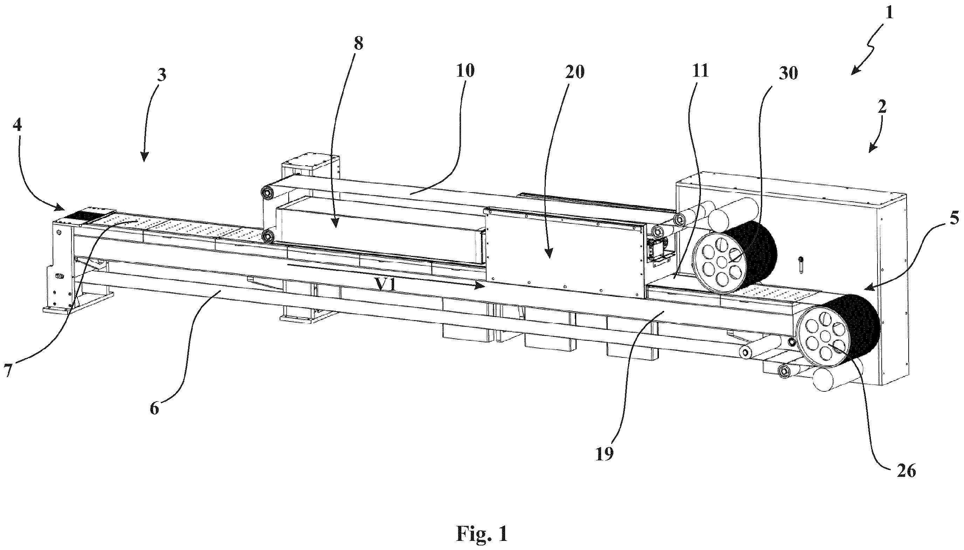

- figure 1 shows a first perspective view of the apparatus for electrically connecting photovoltaic cells in series, object of the present invention;

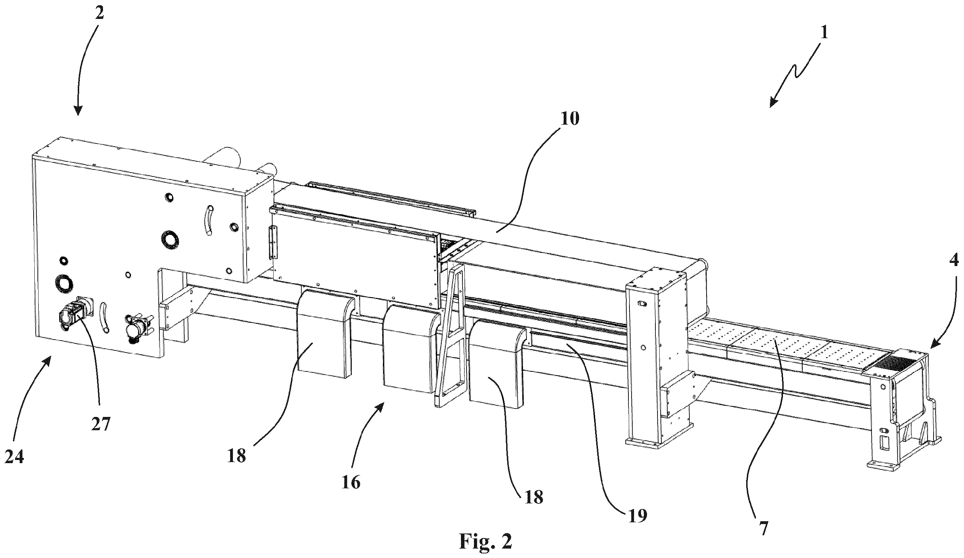

- figure 2 shows a second perspective view of the apparatus of figure 1;
- figure 3 shows a side view of the apparatus of figure 1 with some parts removed in order to better illustrate other parts;
- figure 4 shows a detail of the apparatus of figure 1 relative to a welding station, with some parts removed in order to better illustrate other parts;
- figure 5 shows a further detail of the apparatus of figure 1 relative to a cooling station, with some parts removed in order to better illustrate other parts;
- figure 6 shows a further detail of the apparatus of figure 1 relative to suction means, with some parts removed in order to better illustrate other parts;
- figure 7 shows a cross section view of a detail of the apparatus of figure 1, carried out along the trace VII-VII of figure 3.

### Detailed description of a preferred embodiment

With reference to the enclosed drawings, reference number 1 overall indicates an apparatus for electrically connecting photovoltaic cells in series, according to the present invention.

This is advantageously intended to be employed for making the electrical connection in series between the various photovoltaic cells which form part of photovoltaic panels.

The apparatus 1, object of the present invention, comprises a support structure 2, which is intended to be abutted against the ground and is provided with an advancement lane 3 extended, preferably in a rectilinear manner, between an inlet station 4 and an outlet station 5 of the apparatus 1 and in particular arranged substantially horizontal. According to the invention, the apparatus 1 also comprises a first conveyor belt 6 mounted on the support structure 2 along the advancement lane 3.

The aforesaid first conveyor belt 6 is provided with a first forward section 7, preferably horizontal, which is susceptible of receiving, at inlet station 4, multiple photovoltaic cells in sequence and multiple filiform electrical conductors arranged on at least one face of each of the photovoltaic cells.

Advantageously, the apparatus 1 is intended to be arranged in a plant for producing photovoltaic panels between an apparatus for loading the photovoltaic cells and the electrical conductors (placed at inlet station 4) and an apparatus for picking up a row of photovoltaic cells that are electrically connected in series (placed at outlet station 5), and such apparatuses, not illustrated in the enclosed figures, are advantageously of the type known to the man skilled in the art.

Advantageously, the loading apparatus is provided with a device carrying the photovoltaic cells, stacked on each other, and with a plurality of reels, a corresponding filiform electrical conductor being wound on each of these.

In a per se known manner, the device carrying the photovoltaic cells advantageously comprises a toroidal body circumferentially provided with a plurality of support stations, and on each of these a corresponding stack of photovoltaic cells is arranged. Such toroidal body is susceptible of rotating around a central axis thereof in order to cyclically arrange a corresponding support station at inlet station 4 of the apparatus 1 in order to cyclically bring each stack of photovoltaic cells close to the first conveyor belt 6 of the apparatus 1.

Advantageously, the device carrying the photovoltaic cells also comprises loading means adapted to pick up a photovoltaic cell from the stack of cells arranged at inlet station 4 and to load it on the first conveyor belt 6 of the apparatus 1.

Advantageously, the device carrying the photovoltaic cells also comprises a plurality of instruments for monitoring the photovoltaic cells, adapted to control the conditions of the latter, their alignment on the first conveyor belt 6 and other parameters connected with the good operation of the photovoltaic panel.

Advantageously, the loading apparatus is provided with multiple reels (e.g. twelve), a corresponding filiform electrical conductor being wound on each of these; such conductor is preferably made of copper and covered with a tin alloy, and is known in the jargon of the field with the term "ribbon".

In operation, in a per se known manner, each electrical conductor is unwound from the corresponding reel and is extended above a first photovoltaic cell previously arranged above the first conveyor belt 6. Subsequently, a shearing machine, advantageously arranged between the inlet station 4 of the apparatus 1 and the reels of the loading apparatus, is commanded to cut the various electrical conductors at a distance from the first photovoltaic cell equal to about the size of the photovoltaic cell itself, such that the electrical conductors are arranged for a first half thereof above the first photovoltaic cell and for a second half thereof projecting beyond the latter. Subsequently, a second photovoltaic cell is arranged above the first conveyor belt 6, above the conductors projecting beyond the first photovoltaic cell. In turn, then, above the second photovoltaic cell the electrical conductors are extended, unwound from the reels of the loading apparatus.

In this manner, each electrical conductor is in abutment against one face of a photovoltaic cell and against the opposite face of the next photovoltaic cell in the succession, so as to generate an electrically-in-series connection of the photovoltaic cells in succession.

According to the invention, the first conveyor belt 6 of the apparatus 1 is actuatable in order to make the first forward section 7 advance according to an advancement direction VI so as to convey the photovoltaic cells along the advancement lane 3, and preferably in order to make the photovoltaic cells advance from the inlet station 4 to the outlet station 5.

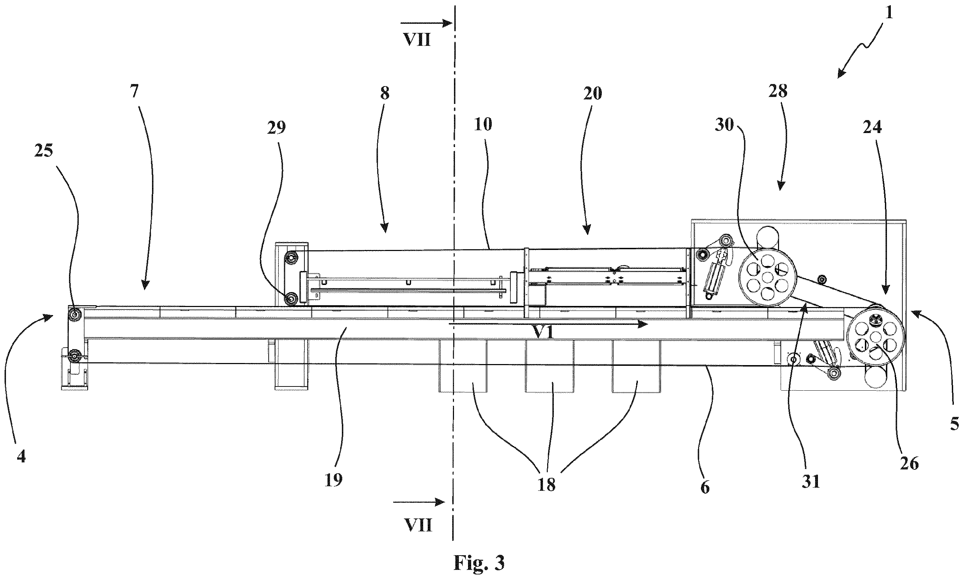

In accordance with the embodiment illustrated in figure 3, the apparatus 1 comprises first movement means 24 adapted to move the first conveyor belt 6. Such first movement means 24 comprise at least one first front roller 25, placed at inlet station 4, and a first rear roller 26, placed at outlet station 5.

Advantageously, the first front and rear rollers 25, 26 are rotatably supported by the support structure 2 and are arranged with their rotation axis orthogonal to the advancement direction VI and preferably substantially horizontal.

Advantageously, the first conveyor belt 6 is closed as a loop and is at least partially wound around the first front and rear rollers 25, 26, with the first forward section 7 defined between the point of abutment of the first conveyor belt 6 on the first front roller 25 and the point of abutment of the first conveyor belt 6 on the first rear roller 26. Advantageously, the first movement means 24 comprise a motor 27, preferably electric, mechanically connected to the first front roller 25 or first rear roller 26.

In accordance with the embodiment illustrated in the enclosed figures, the motor 27 is connected to the first rear roller 26 in order to drive the latter in rotation so as to drive the first forward section 7 of the first conveyor belt 6 to advance according to the advancement direction VI. Preferably, the first front roller 25 is idle and is conducted in rotation by the first conveyor belt 6.

According to the invention, the apparatus 1 also comprises a welding station 8 arranged along the advancement lane 3 between the inlet station 4 and the outlet station 5 and crossed by the first forward section 7 of the first conveyor belt 6.

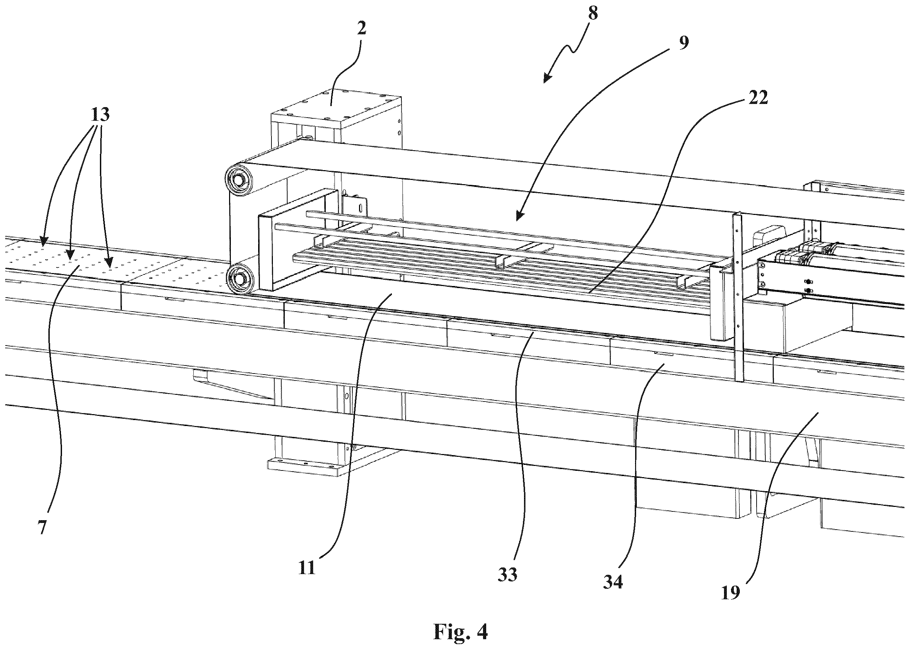

The welding station 8 is provided with first heating means 9 actuatable in order to at least partially melt the electrical conductors so as to weld them to the photovoltaic cells. In accordance with the embodiment illustrated in figure 4, the first heating means 9 comprise at least one irradiation heating device 22, and preferably multiple irradiation heating devices 22, for example infrared lamps.

Advantageously, each irradiation heating device 22 is mounted, preferably by means of a support framework, on the support structure 2, is arranged above the first forward section 7 of the first conveyor belt 6 and is directed towards the first forward section 7 in order to emit radiations towards the photovoltaic cells and the electrical conductors. In accordance with a different embodiment, not illustrated in the enclosed figures, the first heating means 9 comprise an electromagnetic induction heating device, which is susceptible of generating an electromagnetic field at the photovoltaic cells and at the electrical conductors, generating eddy currents within the photovoltaic cells and within the electrical conductors themselves; such eddy currents generate heat via Joule effect in order to bring the electrical conductors at least partially to melting.

Advantageously, the electromagnetic induction heating device is mounted on the support structure 2 above the first forward section 7 of the first conveyor belt 6 and is configured for generating the electromagnetic field at the photovoltaic cells and at the electrical conductors.

Advantageously, in the welding station 8, the photovoltaic cells and the electrical conductors are brought to a temperature of about 220° C, sufficient for melting the tin that covers the electrical conductors and allowing the welding of the latter to the photovoltaic cells.

According to the invention, the apparatus 1 also comprises a second conveyor belt 10 mounted on the support structure 2 along the advancement lane 3 and arranged above the first conveyor belt 6.

The second conveyor belt 10 is provided with a second forward section 11 passing at least through the welding station 8 and placed facing the first forward section 7 of the first conveyor belt 6, and preferably parallel to the latter, delimiting with the first forward section 7 an advancement path 12 which passes at least through the welding station 8.

In addition, the second conveyor belt 10 is actuatable in order to make the second forward section 11 advance in the advancement direction VI so as to drive the photovoltaic cells and the electrical conductors along the advancement path 12 between the first forward section 7 and the second forward section 11.

In accordance with the embodiment illustrated in figure 3, the apparatus 1 comprises second movement means 28 which are adapted to move the second conveyor belt 10 and comprise preferably at least one second front roller 29 and one second rear roller 30.

Advantageously, the second front and rear rollers 29, 30 are rotatably supported by the support structure 2 and are arranged with their rotation axis orthogonal to the advancement direction VI and preferably horizontal.

Advantageously, the second conveyor belt 10 is closed as a loop and is at least partially wound around the second front and rear rollers 29, 30, with the second forward section 11 defined between the point of abutment of the second conveyor belt 10 on the second front roller 29 and the point of abutment of the second conveyor belt 10 on the second rear roller 30.

Advantageously, the apparatus 1 comprises transmission means 31, operatively connected to the electric motor 27 of the first movement means 24 and to the second movement means 28 in order to drive the latter in rotation.

Preferably, the transmission means 31 are mechanically connected to the second rear roller 30 in order to drive it in rotation so as to drive the second forward section 11 of the second conveyor belt 10 to advance according to the advancement direction V1. The second front roller 29 is advantageously idle and conducted in rotation by the second conveyor belt 10.

According to the invention, the first forward section 7 of the first conveyor belt 6 is provided with an upper face 14, directed towards the second forward section 11 of the second conveyor belt 10, and with a lower face 15 directed in the sense opposite the upper face 14. The photovoltaic cells and the electrical conductors are arranged in abutment on the aforesaid upper face 14 of the first conveyor belt 6.

According to the idea underlying the present invention, the first conveyor belt 6 is provided with through holes 13 susceptible of being crossed by the air.

The through holes 13 of the conveyor belt 6 can be obtained with different sizes, susceptible of allowing the passage of air. For example, the through holes 13 can have size of several millimeters and be seen with the naked eye. Otherwise, the through holes 13 can have size on the order of several tenths of a millimeter, or still more preferably smaller than a tenth of a millimeter.

In particular, according to a preferred embodiment of the present invention, the first conveyor belt 6 is made of micro-perforated material and the through holes 13 are for example defined by micro-holes of a breathable material or by voids present between the weft and wood threads of a fabric forming the first conveyor belt 6, and hence cannot be seen with the naked eye.

Preferably, the second conveyor belt 10 is impermeable to air, in particular since it is made of a non-breathable material lacking through holes. In this manner, in particular, an air flow can enter and exit from the advancement path 12 only through the first conveyor belt 6, and not through the second conveyor belt 10.

Advantageously, in accordance with a first embodiment of the present invention, the first conveyor belt 6 is made of a thermally conductive material, preferably plastic, provided with the through holes 13 susceptible of being crossed by the air. Advantageously, the second conveyor belt 10 is also made of a thermally conductive material (preferably plastic).

Advantageously, in accordance with a second embodiment of the present invention, the second conveyor belt 10, and preferably also the first conveyor belt 6, are made of a material that is at least partially transparent to the thermal radiations, and in particular at least partially transparent to infrared radiations. For example, the conveyor belts 6, 10 can be composed of glass fiber or Teflon.

Advantageously, in this manner the photovoltaic cells and the electrical conductors are directly heated by the irradiation heating devices 22 of the first heating means 9, i.e. substantially without intermediate heat passages.

In both of the aforesaid particular embodiments, the first conveyor belt 6 is provided with through holes 13 and the second conveyor belt 10 is preferably impermeable to air. According to the invention, moreover, the apparatus 1 comprises suction means 16 arranged along the advancement lane 3 at least at the advancement path 12. Such suction means 16 are provided with at least one suction section 17 arranged at least at welding station 8 below the lower face 15 of the first forward section 7 of the first conveyor belt 6. In particular, the suction section 17 is advantageously arranged facing the lower face 15 and is preferably in fluid communication with the latter.

In addition, the suction section 17 is in fluid communication with the advancement path 12 by means of the through holes 13 of the first conveyor belt 6, in order to create a depression within the advancement path 12 itself, bringing the second forward section 11 of the second conveyor belt 10 to press on the first forward section 7 of the first conveyor belt 6 and, advantageously, to press on the photovoltaic cells and on the electrical conductors at least at welding station 8.

Indeed, in operation, the difference of pressures between the interior and exterior of the advancement path 12 generates a resultant force that pushes the second forward section 11 of the second conveyor belt 10 downward, bringing such second forward section 11 to press on the first forward section 7 of the first conveyor belt 6.

Advantageously, the second conveyor belt 10 presses the electrical conductors to adhere - for the entire extension thereof - on the photovoltaic cells, and consequently the welding between the photovoltaic cells and the electrical conductors is extended along the entire extension of the latter, thus ensuring an optimal electrical connection between the photovoltaic cells and the electrical conductors.

In accordance with the embodiment illustrated in the enclosed figures, the first heating means 9 of the welding station 8 are arranged above the second forward section 11 of the second conveyor belt 10.

Advantageously, moreover, each irradiation heating device 22 of the first heating means 9 is directed towards the second forward section 11 in order to emit radiation at least on the second forward section 11 of the second conveyor belt 10 in order to heat, directly or indirectly, the electrical conductors and the photovoltaic cells arranged below the second conveyor belt 10.

More in detail, according to the aforesaid above-described first embodiment, in which the second conveyor belt 10 is made of thermally conductive material, the second forward section 11 of the second conveyor belt 10 is heated by the radiation emitted by the irradiation heating device 22 and is susceptible of transmitting, via thermal conduction, heat to the electrical conductors and to the photovoltaic cells against which it is pressed in abutment along at least the second forward section 11.

Consequently, the photovoltaic cells and the electrical conductors are heated at a constant temperature for the entire extension thereof. Such expedient advantageously allows uniformly heating the electrical conductors and the photovoltaic cells, significantly reducing the formation of cracks due to heat expansions of the heated elements.

In addition, this allows the present apparatus 1 to operate in an efficient manner even on electrical conductors with limited section and with circular form, since the heat is uniformly transmitted through the entire extension of the second forward section 11 of the second conveyor belt 10 and is not limited to specific welding points as in previously-discussed machines of known type.

In addition, the present apparatus 1 allows efficiently welding numerous electrical conductors (e.g. twelve) to the photovoltaic cells, since it ensures a correct positioning of the electrical conductors and of the cells and transmits the heat through the entire second forward section 11 of the second conveyor belt 10.

Advantageously, in accordance with the aforesaid above-described second embodiment, in which at least the second conveyor belt 10 is made of material that is at least partially transparent to the thermal radiations, the irradiation devices 22 directly heat, via irradiation, the electrical conductors and the photovoltaic cells arranged below the second forward section 11 of the second conveyor belt 10.

Advantageously, also in such second embodiment, the electrical conductors and the photovoltaic cells are uniformly heated along the welding station 8, since at least one fraction of the heat radiation is not absorbed or deflected by the second forward section 11 of the second conveyor belt 10. In particular, such second embodiment of the present invention allows controlling, in a more precise manner, the heat and the temperature of the electrical conductors and of the cells, therefore optimizing the welding process. Consequently, also the second embodiment of the present apparatus 1 allows limiting the formation of cracks due to heat expansions of the photovoltaic cells and of the heated electrical conductors.

In addition, also such second embodiment allows the apparatus 1 to operate in an efficient manner even over numerous electrical conductors with limited section and with circular shape, since the first heating means 9 uniformly transmit the heat through the entire extension of the welding station 8 and simultaneously the suction means 16 ensure a correct positioning of the electrical conductors and of the photovoltaic cells over the entire extension of the welding station 8 itself.

Advantageously, moreover, with respect to the first embodiment, in such second embodiment, the second conveyor belt 10 remains at a substantially constant temperature for the entire extension thereof and in particular remains at a temperature substantially lower than the temperature at which the photovoltaic cells and the electrical conductors are heated.

Advantageously, also in the embodiment in which the first heating means 9 comprise electromagnetic induction heating devices, the second conveyor belt 10 (being made of dielectric material) remains at a substantially constant temperature for the entire extension thereof and in particular remains at a temperature substantially lower than the temperature at which the photovoltaic cells and the electrical conductors are heated. Advantageously, the suction section 17 of the suction means 16 is extended along the advancement lane 3 at least for the second forward section 11 of the second conveyor belt 10, in order to ensure the creation of the depression within the entire advancement path 12 and ensure the advancement of the electrical conductors to the photovoltaic cells.

Advantageously, the suction means 16 also comprise at least one suction pump (not illustrated in the enclosed figures) and at least one manifold tunnel 19, which is extended along the advancement lane 3 at least at the second forward section 11 of the second conveyor belt 10 and, preferably, along the entire first forward section 7 of the first conveyor belt 6.

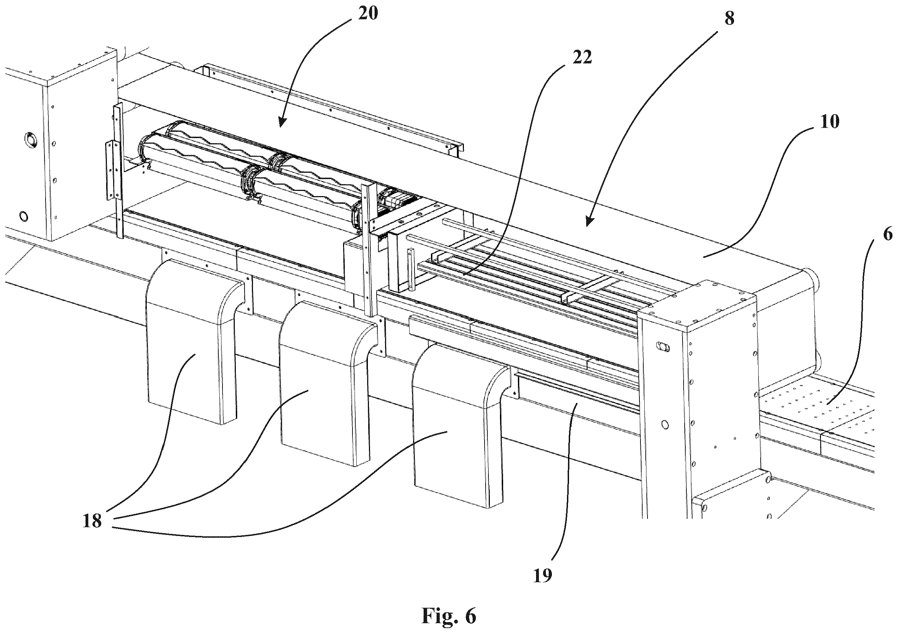

In accordance with the embodiment illustrated in figure 6, the manifold tunnel 19 is connected to the suction pump by means of one or more suction ducts 18.

Advantageously, moreover, the manifold tunnel 19 comprises the suction section 17, which is provided with one or more openings 17' arranged below the lower face 15 of the first forward section 7 of the first conveyor belt 6. In this manner, the suction pump is in fluid communication with the advancement path 12 and, by actuating the suction pump, it is possible to create the depression within the advancement path 12.

In accordance with the preferred embodiment, the manifold tunnel 19 is extended in a continuous manner along the entire the advancement lane 3 between the inlet station 4 and the outlet station 5 in order to exert a suction force also outside the advancement path 12, in order to maintain the photovoltaic cells and the electrical conductors in a correct mutual position along the entire the advancement lane 3.

Advantageously, the depression within the advancement path 12, in addition to ensuring the adherence of the electrical conductors to the photovoltaic cells and to maintaining the latter in position, allows considerably reducing the amount of oxygen in contact with the electrical conductors.

The latter expedient is particularly advantageous since, in order to carry out a good welding, it is important to have non-oxidized electrical conductors so as to avoid the onset of cracks within the welding itself.

Conventionally, in order to prevent the oxidation of the electrical conductors, a pickling operation thereof is carried out, which is attained (in a manner per se known to the man skilled in the art) by means of the deposition of a flux product on the external surface of the electrical conductors, which insulates the electrical conductors themselves from the surrounding air.

However, the flux only effectively protects the surfaces of the electrical conductors from oxidation for a limited time period and for a limited range of temperatures, and thus it is important to opportunely proceed with the welding in order to ensure the non-oxidation of the metal.

Advantageously, the reduction of the oxygen amount within the advancement path 12 further prevents the oxidation of the electrical conductors.

In accordance with the preferred embodiment, the apparatus 1, object of the present invention, comprises second heating means 23 arranged below the first forward section 7 of the first conveyor belt 6 between the first forward section 7 and the suction means 16.

In operation, in the first embodiment described above, in which the first conveyor belt 6 is made of thermally conductive material, the second heating means 23 are susceptible of acting on the first forward section 7 in order to heat it. Advantageously, in such first embodiment, the first forward section 7 of the first conveyor belt 6 is susceptible of transmitting, via thermal conduction, the heat generated by the second heating means 23 to the photovoltaic cells and to the electrical conductors.

Advantageously, in the second embodiment described above, in which the first conveyor belt 6 is made of a material that is at least partially transparent to the thermal radiations, the second heating means 23 are susceptible of heating directly via irradiation the photovoltaic cells and the electrical conductors arranged on the first conveyor belt 6 itself.

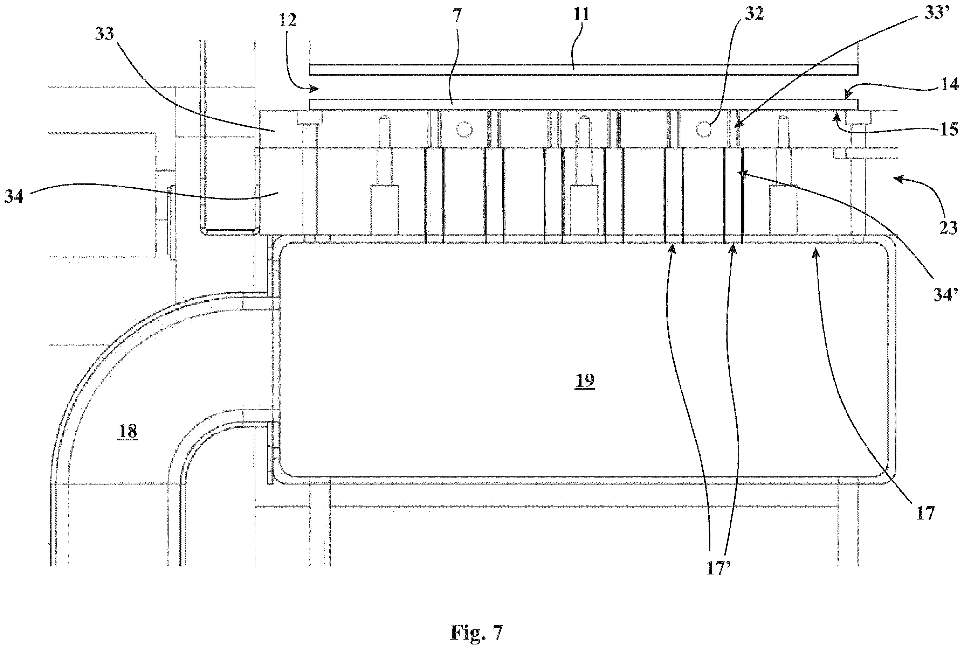

More in detail, in accordance with the embodiment illustrated in figure 7, the second heating means 23 comprise at least one heating support element 33 extended along the advancement lane 3 to support the first forward section 7 of the first conveyor belt 6, and preferably in contact with the lower face 15 of the first forward section 7.

Such heating support element 33 is advantageously provided with a housing for an electrical heating device 32, such as for example an electrical heating element, which is susceptible of heating the heating support element 33 itself. The latter, being advantageously made of a thermally conductive material, e.g. aluminum, is susceptible of being heated and, in the first embodiment, is susceptible of heating via thermal conduction the first forward section 7 of the first conveyor belt 6. In turn, the first forward section 7 is susceptible of heating via thermal conduction the photovoltaic cells and the electrical conductors arranged thereon.

Otherwise, in the second embodiment, the heating support element 33 is susceptible of transmitting heat via irradiation for directly heating the photovoltaic cells and the electrical conductors arranged on the first forward section 7 of the first conveyor belt 6. Advantageously, the second heating means 23 is continuously extended along the entire the advancement lane 3 between the inlet station 4 and the outlet station 5 and are susceptible of carrying out a pre-mixing of the photovoltaic cells and of the electrical conductors before the welding station 8, in order to prevent thermal shocks at the entrance into the welding station 8 itself.

Advantageously, the temperature of the photovoltaic cells and of the electrical conductors at the entrance of the welding station 8 is about 80° C and within the station reaches up to about 220° C.

Preferably, the second heating means 23 also comprise an insulating support element 34, which is extended along the advancement lane 3 and is interposed between the heating support element 33 and the manifold tunnel 19 of the suction means 16, so as to thermally insulate the manifold tunnel 19 itself from the heating support element 33.

In accordance with the embodiment illustrated in figure 7, the heating support element 33 and the insulating element 34 are provided with corresponding through holes 33', 34' placed at openings 17' of the suction section 17 in order to ensure the fluid connection between the manifold tunnel 19 and the advancement path 12.

Preferably, the apparatus 1, object of the present invention, comprises a cooling station 20 arranged along the advancement lane 3 between the welding station 8 and the outlet station 5.

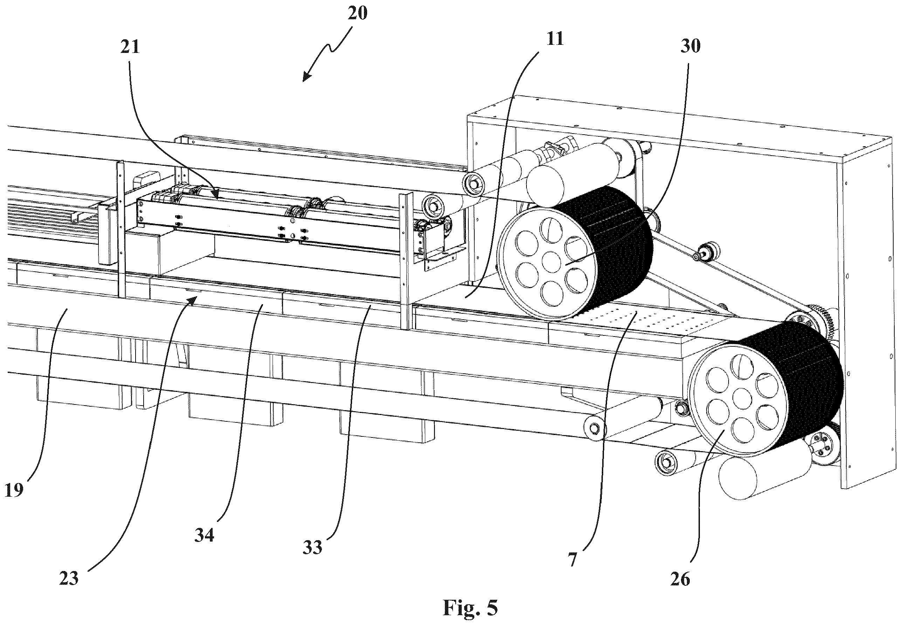

In accordance with the embodiment illustrated in figure 5, the cooling station 20 is provided with ventilation means 21 susceptible of cooling the photovoltaic cells which were electrically connected in series in the welding station 8.

Advantageously, the cooling station 20 is susceptible of gradually lowering the temperature of the photovoltaic cells so as to avoid thermal shocks to the latter at the outlet of the welding station 8.

Preferably, at the inlet of the cooling station 20, the temperature of the photovoltaic cells is about 220° C, and at the outlet of the cooling station 20 the temperature of the photovoltaic cells is about 80° C.

Advantageously, the second advancement section 11 of the second conveyor belt 10 and, therefore, the advancement path 12 (delimited between such second advancement section 11 and the first advancement section 7 of the first conveyor belt 6) are extended along the advancement lane 3 at least through the welding station 8 and, advantageously, also through the cooling station 20, so as to correctly maintain in position the photovoltaic cells and the electrical conductors subjected to the welding operation and, advantageously, to the cooling operation.

Also forming the object of the present invention is a method for operating an apparatus for electrically connecting photovoltaic cells in series of the above-described type; hereinbelow, for the sake of description simplicity, the same nomenclature will be employed.

The present operating method provides for loading a plurality of photovoltaic cells side-by-side in succession on the first conveyor belt 6 and for arranging multiple electrical conductors on at least one face of the photovoltaic cells arranged on the first conveyor belt 6.

Preferably, the present method provides for loading the photovoltaic cells and the electrical conductors by means of a loading apparatus (per se of known type), in a manner such that each electrical conductor is in abutment against one face of a photovoltaic cell and against the opposite face of the next photovoltaic cell in the succession, so as to generate an electrically-in-series connection of the various photovoltaic cells in succession.

The present method then provides for driving, with continuous movement, the first conveyor belt 6 and the second conveyor belt 10 by advancing the first forward section 7 and the second forward section 11 in the advancement direction V1, preferably at the same speed.

The present method then provides for conveying the photovoltaic cells and the electrical conductors in the advancement path 12 between the first forward section 7 of the first conveyor belt 6 and the second forward section 11 of the second conveyor belt 10.

In this manner, the photovoltaic cells and the electrical conductors are advanced inside and through the welding station 8, and preferably also inside and through the cooling station 20.

The present method then provides for heating the electrical conductors and the photovoltaic cells within the welding station 8 by means of the first heating means 9 up to a temperature of at least partial melting of the electrical conductors, so to weld the latter to the photovoltaic cells.

According to the idea underlying the present invention, the present method provides for creating, at least in the welding station 8, a depression within the advancement path 12 by means of the suction means 16, bringing the second forward section 11 of the second conveyor belt 10 to press on the photovoltaic cells and on the electrical conductors placed on the first forward section 7 of the first conveyor belt 6, so as to ensure that the electrical conductors adhere for the entire extension thereof to the photovoltaic cells, so as to obtain a welding along the entire extension of the electrical conductors themselves. Advantageously, the present method provides for cooling the photovoltaic cells exiting from the welding station 8, preferably by means of the ventilation means 21 of the cooling station 20, described above.

Then, the strings of photovoltaic cells connected in series are unloaded from the first conveyor belt 6 at outlet station 5 of the apparatus 1, preferably by means of the abovementioned pick-up apparatus.

The apparatus 1 thus conceived and the method for operating said apparatus therefore attain the pre-established objects.

## Claims

1. Apparatus (1) for electrically connecting photovoltaic cells in series, which comprises:
- a support structure (2) provided with an advancement lane (3) extended between an inlet station (4) and an outlet station (5);
- a first conveyor belt (6), which is mounted on said support structure (2) along said advancement lane (3), is provided with a first forward section (7) susceptible of receiving, at said inlet station (4), multiple photovoltaic cells in sequence and multiple filiform electrical conductors arranged on at least one face of each of said photovoltaic cells, and is actuatable in order to make said first forward section (7) advance according to an advancement direction (V1) in order to convey said photovoltaic cells along said advancement lane (3);
- a welding station (8), which is arranged along said advancement lane (3) between said inlet station (4) and said outlet station (5), is crossed by the first forward section (7) of said first conveyor belt (6), and is provided with first heating means (9) actuatable in order to at least partially melt said electrical conductors so to weld said electrical conductors to said photovoltaic cells;
- a second conveyor belt (10), which is mounted on said support structure (2) along said advancement lane (3) and arranged above said first conveyor belt (6), is provided with a second forward section (11) passing at least through said welding station (8) and placed facing the first forward section (7) of said first conveyor belt (6), delimiting with said first forward section (7) an advancement path (12) passing at least through said welding station (8), and is actuatable in order to make said second forward section (11) advance in said advancement direction (V1) in order to drive said photovoltaic cells and said electrical conductors along said advancement path (12) between said first forward section (7) and said second forward section (11);
wherein the first forward section (7) of said first conveyor belt (6) is provided with an upper face (14) facing the second forward section (11) of said second conveyor belt (10), and with a lower face (15) facing in opposite direction with respect to said upper face (14);
said apparatus (1) being **characterized in that** said first conveyor belt (6) is provided with through holes (13) susceptible of being crossed by the air;
wherein said apparatus (1) comprises suction means (16), which are arranged along said advancement lane (3) at least at said advancement path (12) and are provided with at least one suction section (17), which is arranged at least at said welding station (8) below the lower face (15) of the first forward section (7) of said first conveyor belt (6) and is in fluid communication with said advancement path (12) by means of the through holes (13) of said first conveyor belt (6), in order to create a depression within said advancement path (12), bringing the second forward section (11) of said second conveyor belt (10) to press on the first forward section (7) of said first conveyor belt (6) at least at said welding station (8).

2. Apparatus (1) according to claim 1, **characterized in that** the suction section (17) of said suction means (16) is extended along said advancement lane (3) at least for the second forward section (11) of said second conveyor belt (10).

3. Apparatus (1) according to claim 1 or 2, **characterized in that** said suction means (16) comprise:
- at least one suction pump;
- at least one manifold tunnel (19), which is extended along said advancement lane (3) at least at the second forward section (11) of said second conveyor belt (10), is connected to said suction pump and comprises said suction section (17) provided with one or more openings (17') arranged below the lower face (15) of the first forward section (7) of said first conveyor belt (6).

4. Apparatus (1) according to claim 3, **characterized in that** said manifold tunnel (19) is continuously extended along the entire said advancement lane (3) between said inlet station (4) and said outlet station (5).

5. Apparatus (1) according to any one of the preceding claims, **characterized in that** it comprises a cooling station (20) arranged along said advancement lane (3) between said welding station (8) and said outlet station (5), and provided with ventilation means (21) susceptible of cooling said photovoltaic cells.

6. Apparatus (1) according to any one of the preceding claims, **characterized in that** said first heating means (9) are arranged above the second forward section (11) of said second conveyor belt (10) in order to transmit heat to said second forward section (11), and such said second conveyor belt (10) is made of thermally conductive material in order to transmit, via thermal conduction, said heat to said electrical conductors and to said photovoltaic cells along at least said second forward section (11).

7. Apparatus (1) according to any one of the preceding claims, **characterized in that** said first heating means (9) comprise at least one irradiation heating device (22) acting at least on the second forward section (11) of said second conveyor belt (10).

8. Apparatus (1) according to any one of the preceding claims, **characterized in that** it comprises second heating means (23) arranged below the first forward section (7) of said first conveyor belt (6) between said first forward section (7) and said suction means (16), said first conveyor belt (6) being made of thermally conductive material in order to transmit, via thermal conduction, heat generated by said second heating means (23) to said photovoltaic cells and to said electrical conductors.

9. Apparatus (1) according to any one of claims 1 to 5, **characterized in that** said first heating means (9) comprise at least one irradiation heating device (22) arranged above and directed towards the second forward section (11) of said second conveyor belt (10), and such said second conveyor belt (10) is made of material that is at least partially transparent to thermal radiations, in a manner such to directly heat, via irradiation, said electrical conductors and said photovoltaic cells arranged below the second forward section (11) of said second conveyor belt (10).

10. Apparatus (1) according to claim 9, **characterized in that** it comprises second heating means (23) arranged below the first forward section (7) of said first conveyor belt (6) between said first forward section (7) and said suction means (16), said first conveyor belt (6) being made of material that is at least partially transparent to thermal radiations.

11. Apparatus (1) according to claim 8 or 10, **characterized in that** said second heating means (23) comprise at least one heating support element (33) extended along said advancement lane (3) to support the first forward section (7) of said first conveyor belt (6) and it is susceptible of heating said photovoltaic cells and said electrical conductors arranged on the first forward section (7) of said first conveyor belt (6).

12. Apparatus (1) according to any one of the claims 8, 10 or 11, **characterized in that** said second heating means (23) is continuously extended, along the entire said advancement lane (3), between said inlet station (4) and said outlet station (5).

13. Apparatus (1) according to any one of the preceding claims, **characterized in that** said first conveyor belt (6) is made of micro-perforated material.

14. Apparatus (1) according to any one of the preceding claims, **characterized in that** said second conveyor belt (10) is impermeable to air.

15. Method for operating an apparatus (1) for electrically connecting photovoltaic cells in series according to claim 1, and such operating method provides for:
- loading said plurality of photovoltaic cells side-by-side in succession on said first conveyor belt (6);
- arranging said multiple electrical conductors on at least one face of the photovoltaic cells arranged on said first conveyor belt (6);
- actuating, with continuous movement, said first conveyor belt (6) and said second conveyor belt (10), making said first forward section (7) and said second forward section (11) advance in said advancement direction (V1) in order to transport said photovoltaic cells and said electrical conductors in said advancement path (12) between said first forward section (7) and said second forward section (11), at least to cross said welding station (8);
- heating said electrical conductors and said photovoltaic cells, within said welding station (8), by means of at least said first heating means (9) up to a temperature of at least partial melting of said electrical conductors for welding said electrical conductors to said photovoltaic cells;
said operating method being **characterized in that** it creates, at least in said welding station (8), a depression within said advancement path (12) by means of said suction means (16), bringing the second forward section (11) of said second conveyor belt (10) to press on said photovoltaic cells and said electrical conductors placed on the first forward section (7) of said first conveyor belt (6).

## Patentansprüche

1. Vorrichtung (1) zur elektrischen Verbindung von Solarzellen in Reihe, die Folgendes umfasst:
- eine mit einer zwischen einer Eintrittsstation (4) und einer Austrittsstation (5) verlaufenden Beförderungsbahn (3) ausgestattete Trägerstruktur (2);
- ein erstes Förderband (6), das auf der genannten Trägerstruktur (2) entlang der genannten Beförderungsbahn (3) montiert, mit einem ersten vorderen Abschnitt (7) ausgestattet ist, der geeignet ist, an der genannten Eintrittsstation (4) zahlreiche Solarzellen in Folge und auf mindestens einer Seite jeder der genannten Solarzellen angeordnete zahlreiche fadenartige elektrische Leiter zu erhalten, und angetrieben werden kann, um den genannten ersten vorderen Abschnitt (7) in einer Beförderungsrichtung (V1) vorwärts zu bewegen, um die genannten Solarzellen entlang der genannten Beförderungsbahn (3) zu befördern;
- eine Schweißstation (8), die entlang der genannten Beförderungsbahn (3) zwischen der genannten Eintrittsstation (4) und der genannten Austrittsstation (5) angeordnet, von dem ersten vorderen Abschnitt (7) des genannten ersten Förderbands (6) überquert wird und mit ersten Heizelementen (9) ausgestattet ist, die aktiviert werden können, um die genannten elektrischen Leiter mindestens teilweise zu schmelzen, um die genannten elektrischen Leiter mit den genannten Solarzellen zu verschweißen;
- ein zweites Förderband (10), das auf der genannten Trägerstruktur (2) entlang der genannten Beförderungsbahn (3) montiert und über dem genannten ersten Förderband (6) angeordnet, mit einem mindestens durch die genannte Schweißstation (8) laufenden zweiten vorderen Abschnitt (11) ausgestattet und gegenüber dem ersten vorderen Abschnitt (7) des genannten ersten Förderbands (6) platziert ist und mit dem genannten ersten vorderen Abschnitt (7) einen Beförderungspfad (12) begrenzt, der mindestens durch die genannte Schweißstation (8) verläuft und aktiviert werden kann, um den genannten zweiten vorderen Abschnitt (11) in der genannten Beförderungsrichtung (V1) vorwärts zu bewegen, um die genannten Solarzellen und die genannten elektrischen Leiter entlang des genannten Beförderungspfads (12) zwischen dem genannten ersten vorderen Abschnitt (7) und dem genannten zweiten vorderen Abschnitt (11) zu bewegen;
wobei der erste vordere Abschnitt (7) des genannten ersten Förderbands (6) mit einer zu dem zweiten vorderen Abschnitt (11) des genannten zweiten Förderbands (10) gerichteten oberen Fläche (14) und mit einer im Verhältnis zu der genannten oberen Fläche (14) in entgegengesetzte Richtung zeigenden unteren Fläche (15) ausgestattet ist; wobei die Vorrichtung (1) **dadurch gekennzeichnet ist, dass** das genannte erste Förderband (6) mit Durchgangsöffnungen (13) ausgestattet ist, die geeignet sind, von Luft durchströmt zu werden;
wobei die genannte Vorrichtung (1) Saugelemente (16) umfasst, die entlang der genannten Beförderungsbahn (3) mindestens auf dem genannten Beförderungspfad (12) angeordnet und mit mindestens einem Saugabschnitt (17) ausgestattet sind, der mindestens an der genannten Schweißstation (8) unter der unteren Fläche (15) des ersten vorderen Abschnitts (7) des genannten ersten Förderbands (6) angeordnet und strömungstechnisch mit dem genannten Beförderungspfad (12) mittels der Durchgangsöffnungen (13) des genannten ersten Förderbands (6) verbunden ist, um einen Unterdruck im Inneren des genannten Beförderungspfads (12) zu erzeugen, so dass der zweite vordere Abschnitt (11) des genannten zweiten Förderbands (10) mindestens an der genannten Schweißstation (8) auf den ersten vorderen Abschnitt (7) des genannten ersten Förderbands (6) gedrückt wird.

2. Vorrichtung (1) nach Anspruch 1, **dadurch gekennzeichnet, dass** der Saugabschnitt (17) des genannten Saugelements (16) mindestens auf dem zweiten vorderen Abschnitt (11) des genannten zweiten Förderbands (10) entlang der genannten Beförderungsbahn (3) verläuft.

3. Vorrichtung (1) nach Anspruch 1 oder 2, **dadurch gekennzeichnet, dass** das genannte Saugelement (16) Folgendes umfasst:
- mindestens eine Saugpumpe;
- mindestens einen Verteilertunnel (19), der entlang der genannten Beförderungsbahn (3) mindestens an dem zweiten vorderen Abschnitt (11) des genannten zweiten Förderbands (10) verläuft, an die genannte Saugpumpe angeschlossen ist und den genannten Saugabschnitt (17) umfasst, der mit einer oder mehreren unter der unteren Fläche (15) des ersten vorderen Abschnitts (7) des genannten ersten Förderbands (6) angeordneten Öffnungen (17') ausgestattet ist.

4. Vorrichtung (1) nach Anspruch 3, **dadurch gekennzeichnet, dass** der genannte Verteilertunnel (19) kontinuierlich entlang der gesamten genannten Beförderungsbahn (3) zwischen der genannten Eintrittsstation (4) und der genannten Austrittsstation (5) verläuft.

5. Vorrichtung (1) nach einem beliebigen der vorangegangenen Ansprüche, **dadurch gekennzeichnet, dass** sie eine Kühlstation (20) umfasst, die entlang der genannten Beförderungsbahn (3) zwischen der genannten Schweißstation (8) und der genannten Austrittsstation (5) angeordnet und mit Belüftungselementen (21) ausgestattet ist, die geeignet sind, die genannten Solarzellen zu kühlen.

6. Vorrichtung (1) nach einem beliebigen der vorangegangenen Ansprüche, **dadurch gekennzeichnet, dass** die genannten ersten Heizelemente (9) über dem genannten zweiten vorderen Abschnitt (11) des genannten zweiten Förderbands (10) angeordnet sind, um Wärme an den genannten zweiten vorderen Abschnitt (11) zu übertragen, und das genannte zweite Förderband (10) aus wärmeleitfähigem Material besteht, um die genannte Wärme durch Wärmeleitung an die genannten elektrischen Leiter und die genannten Solarzellen mindestens entlang des genannten zweiten vorderen Abschnitts (11) zu übertragen.

7. Vorrichtung (1) nach einem beliebigen der vorangegangenen Ansprüche, **dadurch gekennzeichnet, dass** die genannten ersten Heizelemente (9) mindestens eine Heizstrahlungsvorrichtung (22) umfassen, die mindestens auf den zweiten vorderen Abschnitt (11) des genannten zweiten Förderbands (10) wirkt.

8. Vorrichtung (1) nach einem beliebigen der vorangegangenen Ansprüche, **dadurch gekennzeichnet, dass** sie zweite Heizelemente (23) umfasst, die unter dem genannten ersten vorderen Abschnitt (7) des genannten ersten Förderbands (6) zwischen dem genannten ersten vorderen Abschnitt (7) und den genannten Saugelementen (16) angeordnet sind, wobei das genannte erste Förderband (6) aus wärmeleitfähigem Material besteht, um die von den genannten zweiten Heizelementen (23) erzeugte Wärme durch Wärmeleitung an die genannten Solarzellen und die genannten elektrischen Leiter zu übertragen.

9. Vorrichtung (1) nach einem beliebigen der Ansprüche 1 bis 5, **dadurch gekennzeichnet, dass** die genannten ersten Heizelemente (9) mindestens eine über dem zweiten vorderen Abschnitt (11) des genannten zweiten Förderbands (10) angeordnete und zu diesem gerichtete Heizstrahlungsvorrichtung (22) umfassen und dieses genannte zweite Förderband (10) aus einem Material besteht, das zumindest teilweise durchgängig für Wärmestrahlung ist, um die unter dem zweiten vorderen Abschnitt (11) des genannten zweiten Förderbands (10) angeordneten genannten elektrischen Leiter und genannten Solarzellen direkt zu erwärmen.

10. Vorrichtung (1) nach Anspruch 9, **dadurch gekennzeichnet, dass** sie unter dem ersten vorderen Abschnitt (7) des genannten ersten Förderbands (6) zwischen dem genannten ersten vorderen Abschnitt (7) und den genannten Saugelementen (16) angeordnete zweite Heizelemente (23) umfasst, wobei das genannte erste Förderband (6) aus einem mindestens teilweise für Wärmestrahlung durchgängigen Material hergestellt ist.

11. Vorrichtung (1) nach Anspruch 8 oder 10, **dadurch gekennzeichnet, dass** die genannten zweiten Heizelemente (23) mindestens ein entlang der genannten Beförderungsbahn (3) verlaufendes Heizträgerelement (33) umfassen, um den ersten vorderen Abschnitt (7) des genannten ersten Förderbands (6) zu unterstützen, das geeignet ist, die auf dem ersten vorderen Abschnitt (7) des genannten ersten Förderbands (6) angeordneten genannten Solarzellen und genannten elektrischen Leiter zu erwärmen.

12. Vorrichtung (1) nach einem beliebigen der Ansprüche 8, 10 oder 11, **dadurch gekennzeichnet, dass** das genannte zweite Heizelement (23) kontinuierliche entlang der gesamten genannten Beförderungsbahn (3) zwischen der genannten Eintrittsstation (4) und der genannten Austrittsstation (5) verläuft.

13. Vorrichtung (1) nach einem oder mehreren der vorangegangenen Ansprüche, **dadurch gekennzeichnet, dass** das genannte erste Förderband (6) aus mikroperforiertem Material besteht.

14. Vorrichtung (1) nach einem oder mehreren der vorangegangenen Ansprüche, **dadurch gekennzeichnet, dass** das genannte zweite Förderband (10) luftundurchlässig ist.

15. Verfahren zur Bedienung einer Vorrichtung (1) zur elektrischen Verbindung von Solarzellen in Reihe nach Anspruch 1, wobei dieses Betriebsverfahren für Folgendes sorgt:
- Laden der genannten Vielzahl von Solarzellen nebeneinander in Folge auf das genannte erste Förderband (6);
- Anordnen der genannten zahlreichen elektrischen Leiter auf mindestens einer Fläche der auf dem genannten ersten Förderband (6) angeordneten Solarzellen;
- Antreiben des genannten ersten Förderbands (6) und des genannten zweiten Förderbands (10) mit kontinuierlicher Bewegung, wobei der genannte erste vordere Abschnitt (7) und der genannte zweite vordere Abschnitt (11) in der genannten Beförderungsrichtung (V1) vorwärts bewegt werden, um die genannten Solarzellen und die genannten elektrischen Leiter in den genannten Beförderungspfad (12) zwischen dem genannten ersten vorderen Abschnitt (7) und dem genannten zweiten vorderen Abschnitt (11) zu bringen, um mindestens die genannte Schweißstation (8) zu überqueren;
- Erwärmen der genannten elektrischen Leiter und der genannten Solarzellen im Inneren der genannten Schweißstation (8) mittels mindestens der genannten ersten Heizelemente (9) auf eine Temperatur bis zum mindestens teilweisen Schmelzen der genannten elektrischen Leiter zum Verschweißen der genannten elektrischen Leiter auf den genannten Solarzellen;
wobei das genannte Betriebsverfahren **dadurch gekennzeichnet ist, dass** es, zumindest in der genannten Schweißstation (8), mittels der genannten Saugelemente (16) einen Unterdruck in der genannten Beförderungsbahn (12) erzeugt und so den zweiten vorderen Abschnitt (11) des genannten zweiten Förderbands (10) dazu bringt, auf die auf dem ersten vorderen Abschnitt (7) des genannten ersten Förderbands (6) platzierten genannten Solarzellen und genannten elektrischen Leiter gepresst zu werden.

## Revendications

1. Dispositif (1) de connexion en série de cellules photovoltaïques, qui comprend :
- une structure de support (2) équipée d'une voie d'avancement (3) étendue entre une station d'entrée (4) et une station de sortie (5) ;
- un premier convoyeur à bande (6), qui est monté sur ladite structure de support (2) le long de ladite voie d'avancement (3), est équipé d'une première section avant (7) susceptible de recevoir, en correspondance de ladite station d'entrée (4), plusieurs cellules photovoltaïques l'une après l'autre et plusieurs conducteurs électriques filiformes agencés sur au moins une face de chacune desdites cellules photovoltaïques, et est actionnable afin de faire avancer ladite première section avant (7) selon une direction d'avancement (V1) afin de transporter lesdites cellules photovoltaïques le long de ladite voie d'avancement (3) ;
- une station de soudage (8), qui est agencée le long de ladite voie d'avancement (3) entre ladite station d'entrée (4) et ladite station de sortie (5), est traversée par la première section avant (7) dudit premier convoyeur à bande (6), et est équipée de premiers moyens de chauffage (9) actionnables afin de fondre au moins partiellement lesdits conducteurs électriques pour souder lesdits conducteurs électriques auxdites cellules photovoltaïques ;
- un deuxième convoyeur à bande (10), qui est monté sur ladite structure de support (2) le long de ladite voie d'avancement (3) et agencé au-dessus dudit premier convoyeur à bande (6), est équipé d'une deuxième section avant (11) passant au moins à travers ladite station de soudage (8) et placé en face de la première section avant (7) dudit premier convoyeur à bande (6), délimitant avec ladite première section avant (7) un parcours d'avancement (12) passant au moins à travers ladite station de soudage (8), et est actionnable afin de faire avancer ladite deuxième section avant (11) dans ladite direction d'avancement (V1) afin d'activer lesdites cellules photovoltaïques et lesdits conducteurs électriques le long dudit parcours d'avancement (12) entre ladite première section avant (7) et ladite deuxième section avant (11) ; dans lequel la première section avant (7) dudit premier convoyeur à bande (6) est équipée d'une face supérieure (14) orientée vers la deuxième section avant (11) dudit deuxième convoyeur à bande (10), et d'une face inférieure (15) orientée vers la direction opposée par rapport à ladite face supérieure (14) ;
ledit dispositif (1) étant **caractérisé en ce que** ledit premier convoyeur à bande (6) est équipé d'orifices de passage (13) susceptibles d'être traversés par de l'air ;
dans lequel ledit dispositif (1) comprend des moyens d'aspiration (16), qui sont agencés le long de ladite voie d'avancement (3) au moins sur ledit parcours d'avancement (12) et sont équipés d'au moins une section d'aspiration (17), qui est agencée au moins en correspondance de ladite station de soudage (8) en-dessous de la face inférieure (15) de la première section avant (7) dudit premier convoyeur à bande (6) et est en communication fluidique avec ledit parcours d'avancement (12) au moyen d'orifices traversants (13) dudit premier convoyeur à bande (6), afin de former une cavité à l'intérieur dudit parcours d'avancement (12), en amenant la deuxième section avant (11) dudit deuxième convoyeur à bande (10) à presser contre la première section avant (7) dudit premier convoyeur à bande (6) au moins en correspondance de ladite station de soudage (8).

2. Dispositif (1) selon la revendication 1, **caractérisé en ce que** la section d'aspiration (17) desdits moyens d'aspiration (16) est étendue le long de ladite voie d'avancement (3) au moins pour la deuxième section avant (11) dudit deuxième convoyeur à bande (10).

3. Dispositif (1) selon la revendication 1 ou 2, **caractérisé en ce que** lesdits moyens d'aspiration (16) comprennent :
- au moins une pompe d'aspiration ;
- au moins un tunnel distributeur (19), qui est étendu le long de ladite voie d'avancement (3) au moins en correspondance de la deuxième section avant (11) dudit deuxième convoyeur à bande (10), est relié à ladite pompe d'aspiration et comprend ladite section d'aspiration (17) équipée d'une ou plusieurs ouvertures (17') disposées en-dessous de la face inférieure (15) de la première section avant (7) dudit premier convoyeur à bande (6).

4. Dispositif (1) selon la revendication 3, **caractérisé en ce que** ledit tunnel distributeur (19) est étendu en continu tout au long de ladite voie d'avancement (3) entre ladite station d'entrée (4) et ladite station de sortie (5).

5. Dispositif (1) selon l'une quelconque des revendications précédentes, **caractérisé en ce qu'**il comprend une station de refroidissement (20) agencée le long de ladite voie d'avancement (3) entre ladite station de soudage (8) et ladite station de sortie (5), et équipée de moyens d'aération (21) susceptibles de refroidir lesdites cellules photovoltaïques.

6. Dispositif (1) selon l'une quelconque des revendications précédentes, **caractérisé en ce que** lesdits premiers moyens de chauffage (9) sont agencés au-dessus de la deuxième section avant (11) dudit deuxième convoyeur à bande (10) afin de transmettre de la chaleur à ladite deuxième section avant (11), et un tel deuxième convoyeur à bande (10) est constitué d'un matériau conducteur de chaleur afin de transmettre, à travers une conduction thermique, ladite chaleur auxdits conducteurs électriques et auxdites cellules photovoltaïques le long au moins de ladite deuxième section avant (11).

7. Dispositif (1) selon l'une quelconque des revendications précédentes, **caractérisé en ce que** lesdits premiers moyens de chauffage (9) comprennent au moins un dispositif de chauffage par irradiation (22) agissant au moins sur la deuxième section avant (11) dudit deuxième convoyeur à bande (10).

8. Dispositif (1) selon l'une quelconque des revendications précédentes, **caractérisé en ce qu'**il comprend des deuxièmes moyens de chauffage (23) agencés en-dessous de la première section avant (7) dudit premier convoyeur à bande (6) entre ladite première section avant (7) et lesdits moyens d'aspiration (16), ledit premier convoyeur à bande (6) étant constitué d'un matériau conducteur de chaleur afin de transmettre, par conduction thermique, la chaleur générée par lesdits deuxièmes moyens de chauffage (23) auxdites cellules photovoltaïques et auxdits conducteurs électriques.

9. Dispositif (1) selon l'une quelconque des revendications 1 à 5, **caractérisé en ce que** lesdits premiers moyens de chauffage (9) comprennent au moins un dispositif de chauffage par irradiation (22) agencé au-dessus et dirigé vers la deuxième section avant (11) dudit deuxième convoyeur à bande (10), et un tel deuxième convoyeur à bande (10) est constitué d'un matériau qui est au moins partiellement transparent aux rayonnements thermiques, de manière à chauffer directement, par irradiation, lesdits conducteurs électriques et lesdites cellules photovoltaïques agencés en dessous de la deuxième section avant (11) dudit deuxième convoyeur à bande (10).

10. Dispositif (1) selon la revendication 9, **caractérisé en ce qu'**il comprend les deuxièmes moyens de chauffage (23) agencés en dessous de la première section avant (7) dudit premier convoyeur à bande (6) entre ladite première section avant (7) et lesdits moyens d'aspiration (16), ledit premier convoyeur à bande (6) étant constitué d'un matériau qui est au moins partiellement transparent aux rayonnements thermiques.

11. Dispositif (1) selon la revendication 8 ou 10, **caractérisé en ce que** les deuxièmes moyens de chauffage (23) comprennent au moins un élément de support chauffant (33) étendu le long de ladite voie d'avancement (3) pour supporter la première section avant (7) dudit premier convoyeur à bande (6) et est susceptible de chauffer lesdites cellules photovoltaïques et lesdits conducteurs électriques agencés sur la première section avant (7) dudit premier convoyeur à bande (6).

12. Dispositif (1) selon l'une quelconque des revendications 8, 10 ou 11, **caractérisé en ce que** lesdits deuxièmes moyens de chauffage (23) sont étendus en continu, tout au long de ladite voie d'avancement (3), entre ladite station d'entrée (4) et ladite station de sortie (5).

13. Dispositif (1) selon l'une quelconque des revendications précédentes, **caractérisé en ce que** ledit premier convoyeur à bande (6) est constitué d'un matériau micro-perforé.

14. Dispositif (1) selon l'une quelconque des revendications précédentes, **caractérisé en ce que** ledit deuxième convoyeur à bande (10) est imperméable à l'air.

15. Procédé d'opération d'un dispositif (1) de connexion en série de cellules photovoltaïques selon la revendication 1, et un tel procédé d'opération consistant à :
- charger ladite pluralité de cellules photovoltaïques l'une à côté de l'autre en succession sur ledit premier convoyeur à bande (6) ;
- agencer lesdits plusieurs conducteurs électriques sur au moins une face des cellules photovoltaïques agencées sur ledit premier convoyeur à bande (6) ;
- actionner, avec un mouvement continu, ledit premier convoyeur à bande (6) et ledit deuxième convoyeur à bande (10), faisant avancer ladite première section avant (7) et ladite deuxième section avant (11) dans ladite direction d'avancement (V1) afin de transporter lesdites cellules photovoltaïques et lesdits conducteurs électriques dans ledit parcours d'avancement (12) entre ladite première section avant (7) et ladite deuxième section avant (11), au moins pour traverser ladite station de soudage (8) ;
- chauffer lesdits conducteurs électriques et lesdites cellules photovoltaïques, à l'intérieur de ladite station de soudage (8), à l'aide d'au moins lesdits premiers moyens de chauffage (9) jusqu'à une température de fusion au moins partielle desdits conducteurs électriques pour souder lesdits conducteurs électriques auxdites cellules photovoltaïques ;
ledit procédé d'opération étant **caractérisé en ce qu'**il forme, au moins dans ladite station de soudage (8), une cavité à l'intérieur dudit parcours d'avancement (12) à l'aide desdits moyens d'aspiration (16), en amenant la deuxième section avant (11) dudit deuxième convoyeur à bande (10) à presser contre lesdites cellules photovoltaïques et lesdits conducteurs électriques placés sur la première section avant (7) dudit premier convoyeur à bande (6).
